# EUROPEAN PATENT APPLICATION

(11) **EP 2 642 507 A2**
(43) Date of publication of application: **25.09.2013**
(21) Application number: 13159842.7
(22) Date of filing: 19.03.2013
(51) Int. Cl.: H01J 37/08, H01J 37/304, H01J 37/305

(54) **Method and apparatus for actively monitoring an inductively-coupled plasma ion source using an optical spectrometer**

(30) Priority: 20.03.2012 US 201213424977
(71) Applicant: FEI COMPANY, Hillsboro, Oregon 97124-5793 (US)
(72) Inventor: Utlaut, Mark, Scappoose, OR Oregon 97056 (US); Kellogg, Sean, Portland, OR Oregon 97213 (US); Parker, N. William, Hillsboro, OR Oregon 97124 (US); Graupera, Anthony, Hillsboro, OR Oregon 97124 (US); Zhang, Shouyin, Portland, OR Oregon 97229 (US); Brundage, Philip, Portland, OR Oregon 97227 (US); Kinion, Doug, Hillsboro, OR Oregon 97124 (US)
(74) Representative: Bakker, Hendrik

(57) **Abstract**

A method and apparatus for actively monitoring conditions of a plasma source for adjustment and control of the source and to detect the presence of unwanted contaminant species in a plasma reaction chamber (220). Preferred embodiments include a spectrometer (252) used to quantify components of the plasma. A system controller is provided that uses feedback loops based on spectral analysis of the plasma to regulate the ion composition of the plasma source. The system also provides end pointing means based on spectral analysis to determine when cleaning of the plasma source is completed.

## Description

### Technical Field of the Invention

The present invention relates generally to methods and structures for active monitoring of an inductively coupled plasma (ICP) ion source in a focused ion beam (FIB) system.

### Background of the Invention

Focused ion beam systems are used in a variety of applications in integrated circuit manufacturing and nanotechnology to create and alter microscopic and nanoscopic structures. Focused ion beams can use a variety of sources to produce ions. Liquid metal ion sources can provide high resolution (a small spot size) but typically produce a low current and are limited in the types of ions available. Different ion species have different properties, which make some ion species more preferable than others for specific applications. For example, whereas helium ions are useful for imaging or light polishing, xenon ions provide higher milling rates that are useful for bulk processing. To produce a very narrow beam for high resolution processing, the current in a beam from an LMIS must be kept relatively low, which means low etch rates and longer processing times. As the beam current is increased beyond a certain point, the resolution rapidly degrades.

Plasma ion sources ionize gas in a plasma chamber and extract ions to form a beam that is focused on a work piece. Plasma ion sources may consist of a single gas species or many different types of gases to provide different species of ions. When compared to LMIS sources, plasma ion sources have larger virtual source sizes and are much less bright. An ion beam from a plasma source, therefore, cannot be focused to as small of a spot as the beam from an LMIS, although a plasma source can produce significantly more current.

Plasma sources, such as a duoplasmatron source described by Coath et al., "A High-Brightness Duoplasmatron Ion Source Microprobe Secondary Ion Mass Spectroscopy," REV. Sci. INST. 66(2), p. 1018 (1995), have been used as ion sources for ion beam systems, particularly for applications in mass spectroscopy and ion implantation. Inductively coupled plasma (ICP) sources have been used more recently with a focusing column to form a focused beam of charged particles, i.e., ions or electrons.

An inductively coupled plasma source is capable of providing charged particles within a narrow energy range, which allows the particles to be focused to a smaller spot than ions from a duoplasmatron source. ICP sources, such as the one described by Keller et al., for "Magnetically enhanced, inductively coupled plasma source for a focused ion beam system," U.S. Pat. No. 7,241,361, which is assigned to the assignee of the present invention and incorporated herein by reference, includes a radio frequency (RF) antenna typically wrapped around a ceramic plasma chamber. The RF antenna provides energy to maintain the gas in an ionized state within the chamber. Because the virtual source size of a plasma source is much larger than the virtual source size of an LMIS, the plasma source is much less bright.

Unfortunately, drift and instabilities in plasma source emission are common. The causes and possible corrective actions for these types of instabilities are often difficult to discern. Various means for monitoring plasma conditions are known, but these methods have a number of disadvantages. Monitoring gas purity or species composition is possible using a mass spectrometer, but the equipment required is expensive, especially for high atomic mass gas species such as xenon (131 AMU). Monitoring plasma density can be achieved using a Langmuir probe, but this is also quite expensive and difficult to implement in a 30 kV plasma. As a result, the active monitoring of plasma conditions for adjustment and control of the source is not done at present.

At present, it is also quite difficult to monitor, control and optimize the distribution of ion species (whether for singly- or multiply-ionized or multi-atomic ions) emitted by ICP ion sources. Monitoring of the ion species would be desirable to ensure the proper species of ions and the desired quantity of said species is being emitted, whether a single species or multiple species is desired. Such monitoring would also be desirable to detect the presence of unwanted contaminant species in plasma reaction chambers. If a mass filtering system is malfunctioning, inadequate, or not employed, such contaminants may travel down the focusing column along with the desired beam species.

What is needed is a method and apparatus for active monitoring of plasma conditions of an inductively coupled plasma (ICP) ion source, both for adjustment and control of the source and to detect the presence of unwanted contaminant species in the plasma reaction chamber.

### Summary of the Invention

An object of the invention is to provide a method and apparatus for actively monitoring conditions of a plasma source for adjustment and control of the source and to detect the presence of unwanted contaminant species in the plasma reaction chamber.

In accordance with preferred embodiments, spectral analysis is used to quantify the components of the plasma and relay other useful information, such as the relative intensity and the composition of ion species within the source tube. Feedback control loops use this information to regulate and monitor the source and other components of the charged particle beam apparatus to ensure proper compliance.

The foregoing has outlined rather broadly the features and technical advantages of the present invention in order that the detailed description of the invention that follows may be better understood. Additional features and advantages of the invention will be described hereinafter. It should be appreciated by those skilled in the art that the conception and specific embodiments disclosed may be readily utilized as a basis for modifying or designing other structures for carrying out the same purposes of the present invention. It should also be realized by those skilled in the art that such equivalent constructions do not depart from the spirit and scope of the invention as set forth in the appended claims.

### Brief Description of the Drawings

For a more thorough understanding of the present invention, and advantages thereof, reference is now made to the following descriptions taken in conjunction with the accompanying drawings, in which:

FIG. 1 is an example spectrum from a xenon plasma source;

FIG. 2 is a schematic diagram of a particle optical apparatus with ICP ion source embodying the light-optical spectrometer monitoring and feedback control of the present invention;

FIG. 3 is a flowchart representing the initial start-up sequence for the ICP ion source according to the invention;

FIG. 4 is a flowchart corresponding to a procedure for oxygen plasma cleaning of the interior of the source tube;

FIG. 5 is a flowchart corresponding to the procedure for bringing the ICP source and FIB column on-line for processing of a sample; and

FIG. 6 is a flowchart corresponding to an optional procedure for endpoint detection using a second spectrometer which collects light emitted from the sample due to the impact of the focused ion beam with the sample surface.

The accompanying drawings are intended to aid in understanding the present invention and, unless otherwise indicated, are not drawn to scale. In the drawings, each identical or nearly identical component that is illustrated in various figures is represented by a like numeral. For purposes of clarity, not every component may be labeled in every drawing.

### Detailed Description of Preferred Embodiments

Preferred embodiments of the present invention employ information available from the optical emission of the IC plasma source to control aspects of both the source and column operation, such as gas switching, gas mixing, cleaning the source tube of contaminants, setting the mass filter selection, and gating the source and column. Applicants have discovered that the ICP source emits sufficient light to allow the optical emissions to be sampled by fiber optic cables and spectrally analyzed. During spectral analysis, the constituent parts of the plasma can be quantified, and both the absolute and relative intensities of the spectral lines are used to provide meaningful information that can be used to control parts of the source and/or system. The spectra can easily be measured with a low-cost spectrometer, such as the USB650 Red Tide Spectrometer available from Ocean Optics. In this invention, the intensity of a multitude of characteristic plasma photon wavelengths is measured in real-time and used in one or more feedback loops regulating the source and/or column, for example, by controlling system operations such as blanking, gas switching, gas-mixing, RF power, cleaning, plasma replenishing, etc.

Preferred embodiments of the present invention thus use the detection and analysis of characteristic photons emitted from a plasma source to assist in the maintenance of optimal plasma conditions for the extraction of charged particles. As seen in a prior art inductively coupled plasma ion source, when xenon is used as the source gas species, a green light is emitted from the plasma and passes through a translucent Al₂O₃ plasma source cell wall. When argon is used as the source gas species, the emitted light has a pink color. Furthermore, it is known that the apparent intensity and color of the plasma also changes due to various input factors such as plasma cell pressure and power transmitted into the plasma. The observed colors are in fact a mixture of characteristic energy photons corresponding to the energy transitions in the atomic levels of the plasma. Although the discrete photon frequencies cannot be distinguished by the human eye, these discrete photon frequencies can be easily distinguished by a typical prior-art spectrometer. In preferred embodiments of the present invention, the relative intensity of a multitude of characteristic plasma photon frequencies is periodically quantified and used as a metric for one or more feedback loops that regulate the plasma conditions for stable, optimized performance. Feedback parameters regulated based upon the intensity of certain photon frequencies could include but are not limited to plasma cell pressure and source power transmitted from the RF generator.

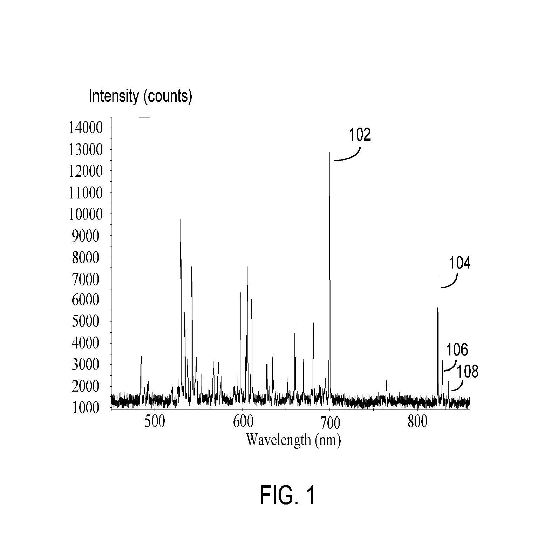

FIG. 1 shows an exemplary spectrum from a xenon plasma source. Applicants have discovered that the intensity of the plasma can be quantified by the intensity ratio of the peaks on the spectrum. For example, the intensity ratio of peak 102 at an approximate wavelength of 700 nm to peaks 104, 106, and/or 108 above a wavelength of 800 nm provides a reliable indicator of the plasma intensity, which can then be used in feedback loops to monitor the plasma source and the components of the ion beam column. Parameters such as plasma cell gas pressure and RF power can then be adjusted, either automatically or by an operator, to achieve a desired optimum source spectrum.

In preferred embodiments of the present invention, the following parameters are examples of the parameters that can be monitored in real time and used to regulate/optimize the plasma conditions:
1) The existence of a plasma within the source tube of the ICP ion source, as evidenced by the collection of light emitted from within the source tube, which may be combined with information on the reflected power returning to the RF power supply;
2) The intensity of plasma generation within the source tube, as evidenced by the intensity of the light emitted from within the source tube;
3) The elemental composition of the plasma within the source tube in cases where multiple gas species are being simultaneously ionized, as evidenced by a spectrometric analysis of the light emitted from within the source tube;
4) The ion species composition in cases of single gas species being ionized - e.g., for ionization of oxygen, the distribution of O⁺, O₂⁺, O²⁺, etc., as evidenced by a spectrometric analysis of the light emitted from within the source tube;
5) The combined ion species composition in gases where multiple gas species are being simultaneously ionized - this is a combination of 3) and 4), above, as evidenced by a spectrometric analysis of the light emitted from within the source tube; and
6) The particle-sample reactions (for example, chemical reactions and non-chemical reactions such as cathodoluminescence and x-ray emission) proceeding at or near the surface of a sample being processed by the ion beam produced by the ICP ion source, as evidenced by the spectrometric analysis of the light emitted from the surface or near the surface.

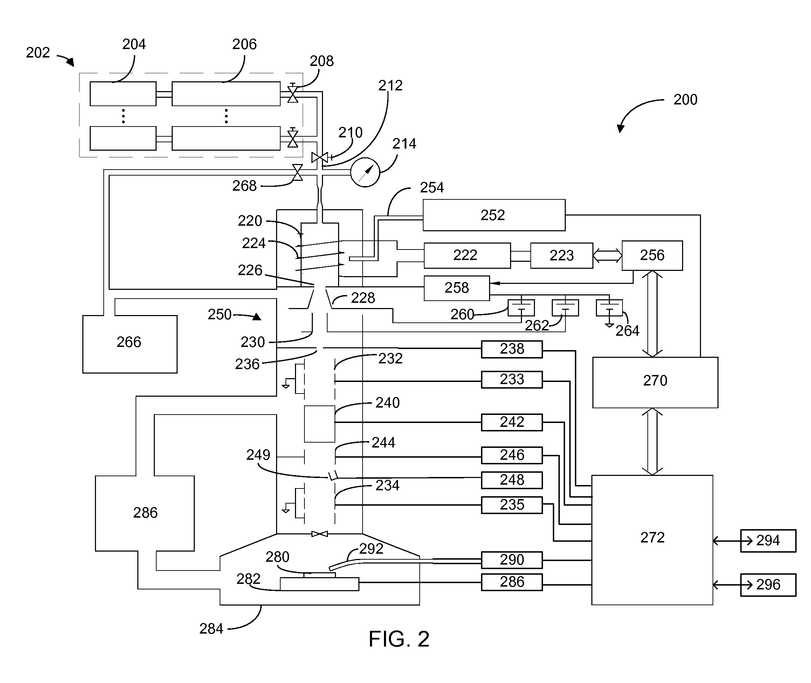

FIG. 2 is a schematic diagram of a particle optical apparatus 200 with an inductively coupled plasma (ICP) ion source embodying the light-optical spectrometer monitoring and feedback control of the present invention. A gas manifold 202 may comprise one or more gas supplies 204 each with its own flow and/or pressure regulator 206. The gas supplies 204 can comprise a variety of different gases or can also be multiple sources of the same gas. Each of the gas supplies 204 may be independently selected by automatic opening of their respective flow valves 208. Activation of a single flow valve corresponds to the case where a single gas species is desired, while activation of more than one flow valve simultaneously corresponds to the case where a gas mixture is desired. The single gas, or gas mixture, is then regulated by a final flow valve 210 leading to gas feed tube 212 to plasma source tube 220, within which a plasma is generated. The plasma source tube can alternatively be called a plasma chamber. A pressure gauge 214 monitors the gas pressure in the gas feed tube 212. The gas feed tube 212 may be evacuated by source turbopump 266 through vent valve 268. Source turbopump 266 can also pump unwanted contaminants, for example, particles from a formed coating, from the source tube 220.

RF power is provided by RF power supply 223 and is fed to the plasma tube 220 through a match box 222 which is connected to an RF antenna 224 surrounding the source tube 220. A split Faraday shield (not shown) is preferably positioned between the antenna 224 and plasma tube 220 to reduce capacitive coupling, thereby reducing the energy spread of the extracted charged particles, and allowing the particles to be focused to a smaller spot. RF power supply 223 could also apply power to the antenna in a "balanced" manner, as described in U.S. Pat. No. 7,241,361, to further reduce energy spread of the particles in the extracted beam. Near the bottom of the plasma source tube 220, a source electrode 226 is biased to a high voltage to apply a high voltage to ions from the plasma. A biasing source power supply 264 is connected to the source biasing electrode 226 and the plasma is initiated by igniter 258. The source biasing electrode can be biased to a large negative voltage when an electron beam or beam of negative ions is to be generated or to a high positive voltage when a beam of positive ions is to be generated. For example, the plasma is typically biased to about positive 30 kV when ions are extracted for ion beam milling; the plasma is typically biased to between about negative 20 kV and negative 30 kV when electrons are extracted for EDS analysis or when negative ions are extracted for secondary ion mass spectrometric analysis; and the plasma is typically biased to between about negative 1 kV and negative 10 kV when electrons are extracted for forming a scanning electron beam image. Use of an ICP with a split faraday shield and a balanced antenna to reduce the beam energy spread facilitates the production of a higher resolution beam which is suitable for some applications in which a large spot size would not be adequate.

An extractor electrode 228 in focusing column 250 is biased by a power supply 260, referenced to the output voltage of the biasing source power supply 264. The extractor electrode power supply 260 may be a bipolar power supply. A condenser electrode 230 in the column is biased by a power supply 262, also referenced to the output voltage of the biasing power supply 264 and also possibly a bipolar power supply.

Ions are extracted from the plasma contained in the source tube 220 due to the high electric field induced at the lower end of the source tube 220 by the bias voltage on the extractor electrode 228 relative to the voltage on the source biasing electrode 226. The ions extracted from the source tube 220 emerge downwards through the opening, or aperture, in the source-biasing electrode 226, forming a charged particle beam (not shown) which enters the optical column 250.

Two electrostatic einzel lenses 232 and 234 within the column are shown for focusing the ion beam onto sample 280 mounted on stage 282, which is controlled by stage control 286 at the bottom of sample chamber 284; however the exact number and type of lenses is not part of the present invention. A sample chamber turbopump 286 ensures a vacuum is maintained within the chamber 284 and column 250 by removing excess gas particles. Turbopump 286 can also be used to remove contaminants from the column 250 and/or sample chamber 284. Electrostatic lenses 232 and 234 are controlled by high voltage power supplies 233 and 235, respectively. The lenses 232 and 234 can be also bipolar lenses. A mass filter 240 controlled by mass filter control 242 may be located within the column for selection of a single ion species out of a multiplicity of ion species which may be produced by the ICP ion source. This multiplicity of ion species may comprise various types of ions of a single element, such as O⁺, O²⁺, or O²⁺, or in the case of multi-element ionization (e.g., O₂ + Xe), this multiplicity of ion species may comprise, for example, O⁺, O²⁺, or O²⁺, combined with Xe⁺. The mass filter 240 typically comprises a deflection in the beam path or a chicane, which is used to separate ions. The particles can be deflected, for example, by a magnetic deflection element such as a dipole or a quadrupole by an E x B mass filter. The position of the mass filter within the column can be varied, for example, to be positioned before the first electrostatic lens 232.

The beam acceptance angle (and thus the total beam current) can be varied by selection of one beam-acceptance aperture (BAA) 236 out of a multiplicity of apertures which may be mechanically positioned onto the beam axis by BAA Actuator 238. In some embodiments, a beam blanker 244, which deflects the beam of charged particles, is controlled by a blanker control 246 and is implemented within the column 250. A Faraday cup 249 can be placed within the column, such that the blanker 244 deflects the beam onto the cup, and an electrometer 248 measures the current of the particles within the beam.

Spectrometer 252 is configured to collect and analyze the light emitted from the plasma (not shown) within the source tube 220. A fiber-optic cable 254 is shown conducting the light emitted through the walls of the source tube 220 (preferably fabricated from Alumina or another translucent ceramic or quartz) to the spectrometer 252. Even though a fiber optic cable 254 is depicted, any light collection means to conduct the light from the source tube 220 to the spectrometer 252 is suitable. In some embodiments, parallel collection of multiple wavelengths of the dispersed light may enable efficient monitoring of the plasma emission spectrum. In other embodiments, a single light collector may be repeatedly scanned across the dispersed light spectrum to produce a time-dependent spectrum signal. Spectrometer 252 therefore provides information that allows the monitoring of the plasma source such that the source remains free of contaminants and such that the desired ion species compositions are employed in the ion beam being focused onto the sample 280.

In preferred embodiments, a second spectrometer 290 collects light emitted from the sample 280 as a result of the impact of the charged particle beam with the sample. The signal from spectrometer 290 may, for example, be used for precise endpoint detection during sample processing. A fiber optic cable 292 can similarly be used to conduct light and transfer the light to spectrometer 290. Although a fiber optic cable 292 is depicted, any light collection means to conduct the light from the sample 280 to the spectrometer 290 is suitable.

A programmable logic controller (PLC) 256 provides control and automation for the RF power source 223 and the igniter 258. The Plasma Source Controller 270 controls the various voltages of the ICP ion source, ion extraction optics, and optionally other components in the system including spectrometer 252, and PLC 256. Plasma Source Controller 270 can also provide feedback to Focused Ion Beam (FIB) System Controller 272 from the PLC 256 and the spectrometer 252. The FIB System Controller 272 has overall responsibility for the proper operation of charged particle apparatus 200, as illustrated by the various control links shown schematically in FIG. 2.

The FIB System Controller 272, for example, is capable of controlling BAA Actuator 238, high-voltage lens power supplies 233 and 235, mass filter control 242, blanker control 246, electrometer 248, spectrometer 290, stage control 286, and Plasma Source Controller 270, which in turn controls other components as described above. The user can input a certain set of operating parameters, such as a pre-defined intensity level or a pre-defined max power, to FIB System Controller 272 or Plasma Controller 270, and these controllers can vary certain system parameters such as RF power, flow, and pressure settings, so that the properties of the plasma match the set of predetermined parameters. The user can also input desired operating parameters such as beam current, lens voltages, beam acceptance angle, mass filter deflection angles, electrode voltages, and beam blanker deflection angles such that the FIB System Controller 272 will monitor and adjust the parameters of the apparatus to match the desired parameters. Skilled persons will recognize that this input can easily be accomplished with a computer or directly to the system controller through another input device.

Preferred embodiments of the system include program memory 294 and data memory 296, which stores data from feedback loops, such as the intensity or composition information as measured from the spectrometer. The collected information from feedback loops can also be displayed, for example, on a computer (not shown) to direct and instruct the user to further action. Information from the feedback loops is used to monitor the conditions of the plasma source and/or the focusing column. In some embodiments, certain operating parameters are adjusted automatically based on analysis of the information from the feedback loops.

The controllers and the memory components can provide automated processes, such as autotuning, which automatically adjusts system parameters such as RF power, pressure, or flow settings based on spectrum feedback from the spectrometer. Autotuning can be used to ensure that the correct ion composition is present. Autostop programs can also be used such that when a certain process reaches its endpoint, that process automatically stops.

Skilled persons will understand that the components of the particle-optical apparatus, i.e. its lenses, mass filter, etc., can be re-arranged and configured differently without compromising its function. Skilled persons will also understand that the operating parameters of the plasma source and the focusing column are typically optimized for the type of particles extracted from the plasma source. Table I shows typical operating parameters for operating with xenon ions and positive oxygen ions. Skilled persons understand that an einzel lens can be operated as an "acceleration lens" or a "deceleration lens," depending on the voltage on the lens, and also that other electrostatic and magnetic lens configurations can perform the same function in place of an einzel lens. In some embodiments, it is preferable to operate the first and second lenses as accelerating lenses when focusing low energy charged particles and as a decelerating lens when focusing high-energy charged particles.

**Table I**

| Operating parameter | Xenon ions | Oxygen ions |
|---|---|---|
| Gas pressure in plasma chamber | .01 mbar to 0.4 mbar | .005 mbar to 0.3 mbar |
| Plasma bias voltage | + 1 kV to + 30 kV | + 1 kV to + 30 kV |
| Extractor electrode voltage (relative to beam voltage) | -2 kV to -15 kV | -2 kV to -15 kV |
| Deflection voltage range | -150 V to + 150 V | -150 V to + 150 V |
| First lens voltage | 0 V to + 30 kV | 0V to+ 30 kV |
| Second lens voltage | -15 V to + 30 kV | -15 V to + 30 kV |
| RF Power | 25 W to 1000 W | 200 W to 1000 W |
| Gas pressure in specimen chamber | 5 x 10⁻⁷ mbar to 1 x 10⁻⁷ mbar | 5 x 10⁻⁷ mbar to 1 x 10⁻⁷ mbar |

In some preferred embodiments of the present invention, the relative intensity of certain characteristic plasma photon frequencies can be used to detect the presence of unwanted contaminant species in plasma reaction chambers. This can be especially valuable, for example, when a different ion species is introduced for another purpose, such as when a cleaning plasma is used. During operation of the ICP system, the source tubes in the ICP ion sources tend to accumulate a coating on their inner walls which reduces the intensity of light collected outside the source. This intensity reduction sometimes causes the control software to (incorrectly) determine that the plasma is absent or below the desired set-level.

To clean the interiors of source tubes *in situ,* oxygen cleaning-plasmas have been proposed. To date, however, there has been no means for determining when these cleaning processes are complete. Excessive exposure to oxygen plasmas in sources configured for operation with more inert gases (e.g., Xe, Ar, or Ne) may reduce the source lifetime through erosion of the source electrode at the exit of the source tube. Thus, a method is needed to determine the level of proper exposure to reactive oxygen plasmas in order to minimize these complications of excessive exposure. In preferred embodiments of the present invention, the relative intensity of certain characteristic plasma photon frequencies can be used to both determine when cleaning of the source is appropriate and also when the source has been sufficiently cleaned.

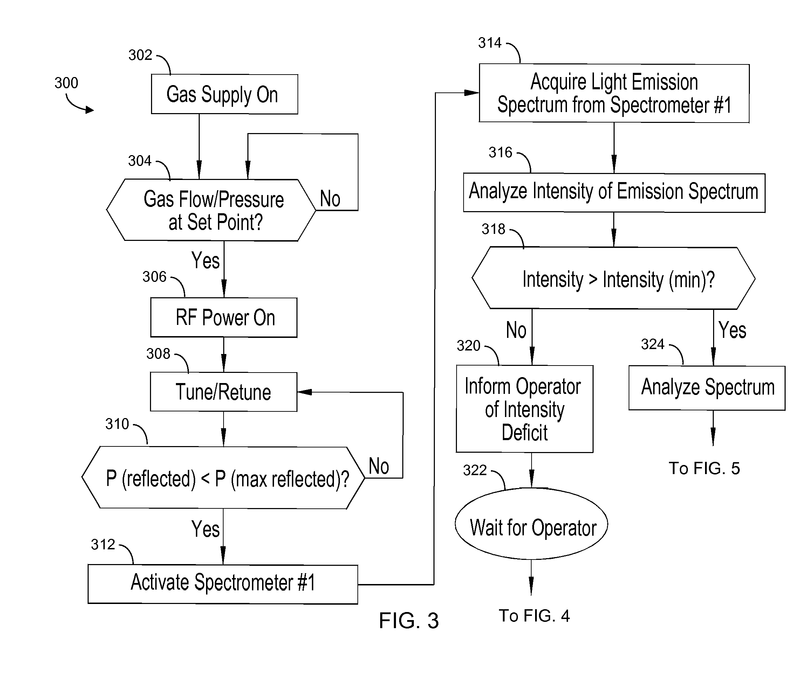

FIGS. 3-5 are flowcharts showing the steps of operating an ICP ion source according to preferred embodiments of the present invention. FIG. 3 is a flowchart 300 representing the initial start-up sequence for the ICP ion source according to the invention. First, in step 302, the gas supply is turned on. As described in FIG. 2, the gas flowing into the source tube 220 of the ICP ion source may comprise one or more different gases, either from separate gas containers or from one or more gas containers which may comprise multi-gas mixtures. In step 304, a pre-defined gas flow and/or pressure setpoint must be reached before turning on the RF supply 223 in step 306. Once the RF supply 223 has been turned on, step 308 includes tuning the match box 222. Step 310 includes monitoring the reflected power back into the RF supply 223 until the reflected power has dropped below a pre-defined maximum reflected power. If the reflected power is not less than a pre-defined max value, the matchbox 222 is re-tuned. This re-tuning of the matchbox can be performed automatically.

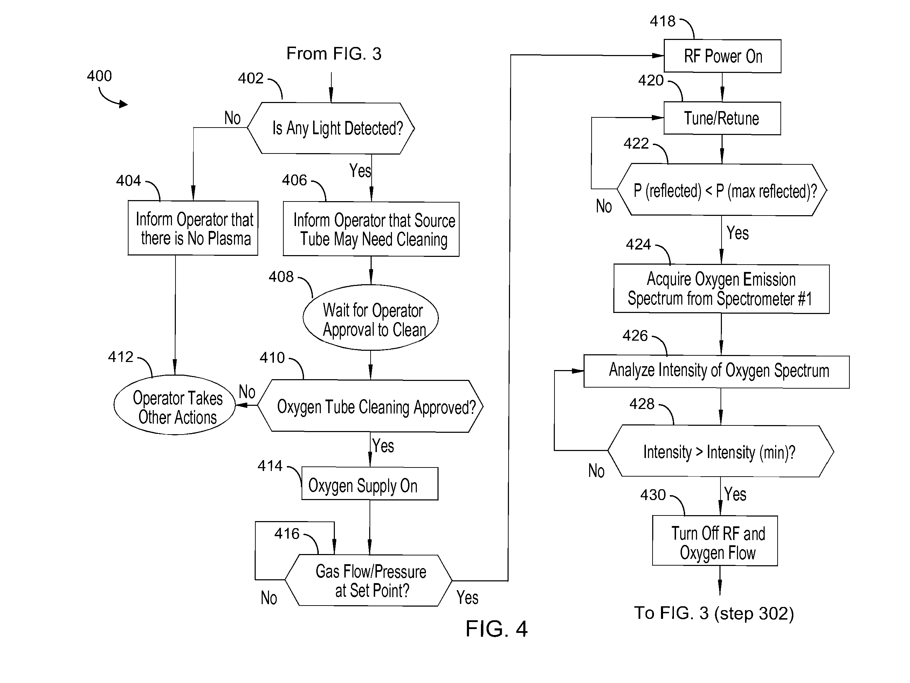

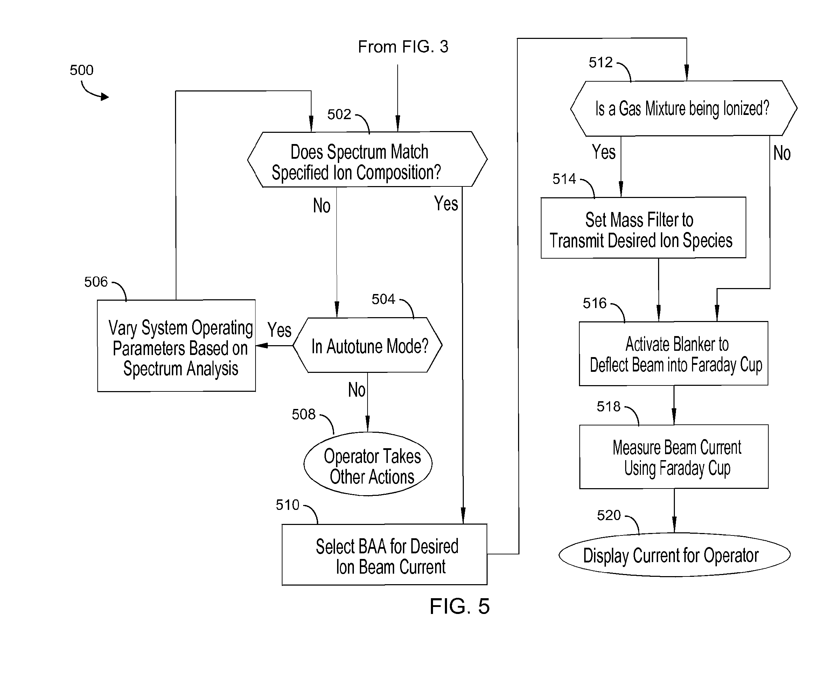

Next, step 312 includes activating spectrometer 252, and, in step 314, the light emitted from a plasma within the source tube 220 is acquired as illustrated in FIG. 2. At first, in step 316, the total emission intensity is analyzed by, for example, determining intensity ratios of its peaks in a certain range, and then, in step 318, the total emission current is compared with a pre-defined minimum light intensity. The specific minimum light intensity for a particular ICP source design can be found empirically, for example by doubling the light intensity of the extinction-threshold plasma condition, the extinction-threshold condition being reached by slowly decreasing the RF power until the point below which plasma is no longer self-sustaining. The minimum light intensity need not be the same for all plasma species, and so should be determined severally as appropriate. If the light intensity falls below this minimum value, the process proceeds with step 320, in which the system operator is informed through the FIB system operator interface, for example through the Plasma Source Controller 270 or FIB System Controller 272, and the system subsequently waits for a response from the operator in step 322, leading to flowchart 400 in FIG. 4. If the light intensity exceeds the minimum value, then step 324 includes analyzing the spectrum, and then the start-up procedure moves on to the process shown in flowchart 500 in FIG. 5.

FIG. 4 is a flowchart 400 corresponding to a procedure for oxygen plasma cleaning of the interior of the source tube. The use of this cleaning process is predicated on the assumption that the reason the detected light emission from the source tube falls below the minimum intensity is that a coating has formed on the inner wall of the source tube, the coating arising from decomposition of either process gases or possibly parts of the source tube and electrode assemblies. This coating is presumed to be of a material, for example, carbon or hydrocarbons which may be oxidized into volatile compounds (e.g., CO, CO₂, H₂O, etc.) which may then be pumped away by the source turbopump 266. Flowchart 400 proceeds from step 322 of FIG. 3. Step 402 includes determining if any light is detected. It is assumed that the coating never becomes so opaque that no light at all may be collected and analyzed by spectrometer 252, thus the decision block 402, in the event that no light is detected, proceeds to step 404, in which the operator is informed that there is no plasma. Subsequently, step 412 effectively involves the operator taking other corrective action, such as replacing one or more of the gas reservoirs 204. Even in a situation where the reflected power back to the RF power supply 223 is below the threshold shown as seen in step 310 in FIG. 3, it is possible for other parts of the ICP source to absorb the RF power even in the absence of a plasma. This scenario is most likely a highly undesirable situation which should be terminated as soon as possible through either operator intervention or an automatic RF power cutoff to prevent excessive heating of portions of the ICP source (especially components such as o-rings which may overheat and outgas or burn up).

When some light is detected, step 406 includes informing the system operator that the source tube may need cleaning. Step 408 includes waiting for operator approval to clean the source tube. Next, step 410 includes the decision step of approving the oxygen tube cleaning. If the operator does not approve source tube cleaning, the process proceeds with step 412, in which flowchart 400 is exited, and the operator then is free to take whatever corrective actions may be deemed necessary, the same as for the case of no light being detected. If the operator does approve the use of oxygen plasma cleaning on the source tube interior, step 414 includes turning on the cleaning oxygen supply. In step 416, a pre-defined gas flow and/or pressure set point must be reached before turning on the RF supply 223 in step 418. Once the RF supply 223 has been turned on, step 420 includes tuning the match box 222.

Step 422 includes monitoring the reflected power back into the RF supply 223 until the reflected power has dropped below a pre-defined maximum reflected power. If the reflected power is not less than a pre-defined max value, the matchbox 222 is retuned until the reflected power is less than the pre-defined maximum power. Once this has been accomplished by adjustments to the settings on the matchbox 222, the method proceeds with step 424, in which an oxygen emission spectrum from the light emitted by the plasma within the source tube 220 is acquired. In step 426, the intensity of this emitted light is then analyzed and monitored in step 428 as an oxygen plasma is maintained within the source tube until the intensity of the emitted light (at a constant plasma power) gradually increases to exceed a predefined intensity level. This analysis of the intensity of the oxygen spectrum provides an endpointing method that determines when cleaning of the plasma tube is complete. This endpointing method is advantageous as overexposure to certain cleaning methods, such as oxygen cleaning plasmas, can be harmful to the plasma source. Once this has been accomplished, step 430 includes turning off both the RF power and the flow of oxygen to the source tube 220. At this point, feedback system of plasma source controller 270 has identified the crucial endpoint for oxygen cleaning of the source tube, such that potential damage from over-cleaning is avoided. The system should then be ready for use and the flowchart of FIG. 3 is reentered at the start block 302.

FIG. 5 is a flowchart 500 corresponding to the procedure for bringing the ICP source and FIB column on-line for processing of a sample. Flowchart 500 is entered after the plasma has been initiated in flowchart 300 in FIG. 3, up to the point of an adequate total light emission ("Yes" exiting from block 318 to block 324) from the source tube 220. In step 502, the spectral data acquired from the source tube 220 is now analyzed more fully, to determine the distribution of ion species within the source tube and to compare this to a predefined desired ion species distribution. If the spectrum does not match, then step 504 includes the system determining whether it has been set to Autotune mode. The composition of source tube can be autotuned, for example, by using automation from the PLC 256 and data from the Plasma Source Controller 270. If not, step 508 includes notifying the operator that the ion species distribution does not match the predefined distribution and the system then waits for the operator to take other actions.

If the system is in Autotune mode, the process proceeds with step 506, in which various system parameters (e.g., RF power, flow and/or pressure settings for each of the process gases, the total pressure in the gas feed tube, etc.) are systematically varied based on predetermined plasma optimization results. These parameters can be varied automatically based on a predetermined set of input values. As this is done in real-time, spectrometer 252 is continuously monitoring and analyzing the light emission from the source tube until the observed emission spectra matches the predefined spectra for the desired ion species. At this point, the decision block leads to step 510, in which the BAA for the desired ion beam current is selected. The BAA actuator may be used to select a larger aperture if the beam current is too low or a smaller aperture if the beam current is too high.

Step 512 is a decision block to determine if a gas mixture is being ionized. If a gas mixture is being ionized, for example, ions of more than one element are being produced by the ICP ion source, then an additional step 514 is required to set-up the mass filter to select the ion species of interest out of the multiplicity of ion species being produced by the ICP ion source. It is important to note that the multiplicity of ion species can be from different elements with different charge and molecular states. Once the mass filter electric and/or magnetic fields have been set to transmit only the ion species of interest or if there is not a gas mixture being ionized, a beam blanker 244 may be used in step 516 to deflect the ion beam into a Faraday cup 249, enabling the beam current which would be focused onto the sample 280 to be precisely measured in step 518. The measured current can be monitored by the system controller 272 and displayed for the system operator in step 520.

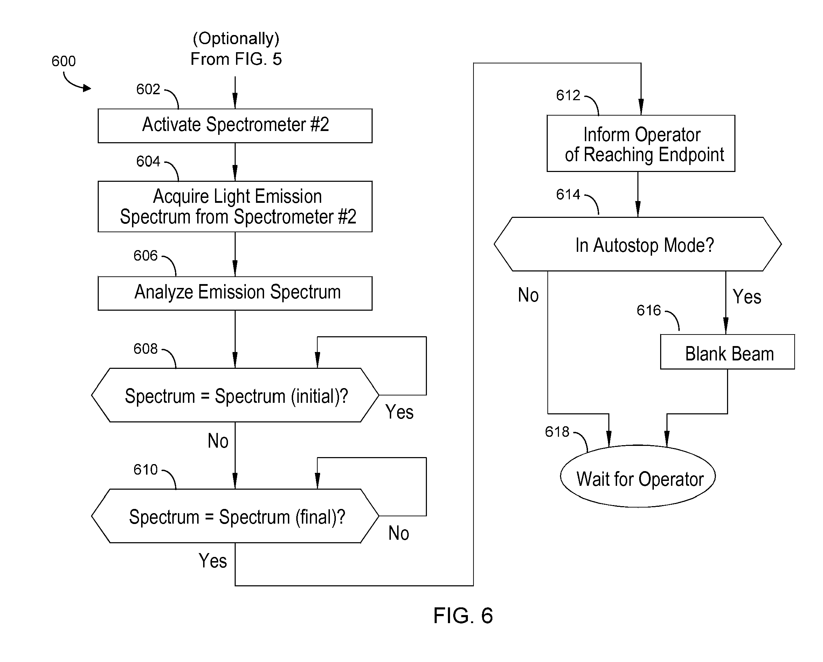

In some preferred embodiments of the present invention, a second spectrometer 290 can be used for endpointing during processing of sample 280 by the focused charged particle beam. FIG. 6 is a flowchart 600 corresponding to an optional procedure in which a second spectrometer 290 collects light emitted from the sample 280 due to the impact of the focused beam with the sample surface and uses the spectral information obtained to determine when sample processing is complete. The procedure would be followed after the successful completion of the procedures illustrated in FIGS. 3 and 5, that is, after step 520. If the procedure described in FIG. 4 is necessary, it would be completed and then the system would return to complete flowchart 300 in FIG. 3 and then flowchart 500 in FIG. 5, before flowchart 600 of FIG. 6 could be followed.

In the process of FIG. 6, spectrometer 290 can have a fiber optic 292 or similar light collecting device directed at the sample surface where the focused ion impacts. Step 602 includes activating spectrometer 290, and subsequently, in step 604, spectral information is acquired and analyzed. Two spectra would be predefined for this endpointing process: 1) an initial spectrum characteristic of the light which would be expected to be emitted by the sample when first impacted by the focused charged particle beam, and 2) a "final" spectrum characteristic of the light which would be expected to be emitted by the sample after processing by the focused beam. Examples of these spectra might be:
1) The spectrum of silicon dioxide, corresponding to the insulating material of a metallization stack on an integrated circuit.
2) The spectrum of copper, corresponding to the conductors within the metallization stack. Normally, these copper conductors would be buried beneath layers of insulating material and the FIB would be used to form high aspect ratio openings to reach these conducting layers in order to perform circuit edit, for example.

During the process described in FIG. 6, as the FIB first mills material away, the emission spectrum from the sample is expected to be that of the initial sample, called "Spectrum (initial)" in step 608. Step 608 loops while this is still the case. Once the analyzed spectrum starts to differ from Spectrum (initial), the procedure moves to the next decision block 610, which compares the analyzed real-time spectra with "Spectrum (final)." For a certain period, determined by the beam processing rate and material thicknesses, the analyzed spectrum will differ from both Spectrum (initial) and Spectrum (final). Once a sufficient amount of break-through using the beam has occurred, the analyzed spectrum will be sufficiently close to Spectrum (final), and in step 612, the system operator will be notified that the process has reached endpoint. The determination of when an analyzed spectrum is sufficiently close to Spectrum (final) will, in practice, is made by the operator either by trial-and-error or by special knowledge of which spectrum types provide adequate endpointing performance in the process underway. Step 614 includes determining if the system is in Autostop mode. If the system has been set in Autostop mode, the beam will be automatically blanked in step 616. If the system has not been set in Autostop mode, it will proceed to step 618 and just wait for the system operator to manually respond by presumably blanking the beam. In addition to etching, this endpointing method can also be applied to other sample processing methods such as deposition.

According to some embodiments of the present invention, a charged particle system comprises a plasma source including a plasma tube for containing a plasma, a conductor for providing radio frequency energy into the plasma tube, a focusing column for focusing a beam of charged particles onto or near a sample, and a first spectrometer for collecting light emitted from within the plasma tube.

In some embodiments, the charged particle beam system further comprises a controller system for regulating the plasma source and/or the focusing column based on analysis of the light collected from the first spectrometer. In some embodiments where user input is provided to the controller system, the user input being incorporated into feedback loops regulates the plasma source and/or focusing column.

In some embodiments, the controller system monitors the existence of plasma within the source tube, the intensity of the plasma within the source tube, the elemental composition of the plasma within the source tube in cases where multiple gas specie are being simultaneously ionized, or the ion species composion of the plasma within the source tube in cases of single gas species being ionized.

In some embodiments, the controller system controls operating parameters of the charged particle beam system such that the properties of the plasma source match a set of predetermined properties. In some embodiments, the charged particle beam system further comprises a second spectrometer for collecting light emitted from the sample. In some embodiments, the analysis of the light collected from the second spectrometer is used to provide endpoint detection during processing of the sample.

According to some embodiments of the present invention, a method of operating an inductively coupled plasma source including a plasma tube comprises providing a flow of a first gas into the plasma source, providing radio frequency energy into the plasma source to maintain a plasma in the plasma tube, extracting charged particles from the plasma tube, focusing the charged particles into a beam within a focusing column and directing the beam onto or near a workpiece, providing a first spectrometer to collect light emitted from within the plasma tube, analyzing the light collected from the first spectrometer, and controlling the plasma source based on the analysis of the light collected from the first spectrometer.

In some embodiments, the method further comprises providing a second spectrometer to collect light emitted from the sample as a result of the impact of the beam with the workpiece and analyzing the light collected from the second spectrometer. In some embodiments, analyzing the light collected from the second spectrometer provides a method of endpoint determination when processing the workpiece.

In some embodiments, the method further comprises upon a determination that the plasma tube should be cleaned, shutting down the flow of the first gas and the radio frequency energy for the plasma source; then, providing a flow of oxygen into the plasma source; restarting the radio frequency energy provided to the source to maintain an oxygen plasma to clean the plasma tube; analyzing the light collected from the first spectrometer to determine whether the oxygen plasma cleaning of the plasma tube is complete based upon the intensity of the emitted light; and once the intensity of the emitted light exceeds a predefined intensity level, shutting down the flow of oxygen and the radio frequency energy for the plasma source.

In some embodiments, the method further comprises after the oxygen plasma cleaning has been completed, restarting the flow of a first gas into the plasma source, providing radio frequency energy into the plasma source to maintain a plasma in the plasma tube, extracting charged particles from the plasma tube, and focusing the charged particles into a beam within a focusing column and directing the beam onto or near a workpiece.

In some embodiments, the method further comprises providing a user input that includes a set of predetermined plasma source properties and is incorporated in controlling the plasma source using feedback loops such that the plasma source is adjusted to match the set of predetermined plasma source properties.

In some embodiments, controlling the plasma source based on the analysis of the emission spectrum of light collected from the first spectrometer includes monitoring the existence of plasma within the source tube, the intensity of plasma generation within the source tube, the elemental composition of the plasma within the source tube in cases where multiple gas species are being simultaneously ionized, the ion species composition of the plasma in cases of a single species being ionized, or the combined ion species composition of the plasma where multiple gas species are being simultaneously ionized.

In some embodiments, controlling the plasma source includes varying operating parameters so that properties of the light collected from the first spectrometer match properties of a desired ion composition. In some embodiments, the method further comprises controlling components of the focusing column. In some embodiments, controlling components of the focusing column includes controlling a mass filter to transmit a desired ion species, selecting a beam acceptance aperture for a desired ion beam current or controlling the voltages on focusing lenses. In some embodiments, controlling the plasma source is an automated process.

According to some embodiments of the present invention, a method of operating an inductively coupled plasma source including a plasma tube comprising providing a flow of a first gas into the plasma source, providing radio frequency energy into the plasma source ot maintain a plasma in the tube, extracting charged particles from the plasma tube, and focusing the charged particles into a beam within a focusing column and directing the beam onto or near a workpiece; characterized in that after light emitted from within the plasma tube is collected by a first spectrometer, the plasma source is controlled based on an analysis of the light collected from the first spectrometer, the plasma source is controlled based on an analysis of the light collected from the first spectrometer.

In some embodiments, the method further comprises providing a second spectrometer to collect light emitted from the sample as a result of the impact of the beam with the workpiece and analyzing the light collected from the second spectrometer. In some embodiments, analyzing the light collected from the second spectrometer provides a method of endpoint determination when processing the workpiece.

In some embodiments, the method further comprises upon a determination that the plasma tube should be cleaned, shutting down the flow of the first gas and the radio frequency energy for the plasma source; then, providing a flow of oxygen into the plasma source; restarting the radio frequency energy provided to the source to maintain an oxygen plasma to clean the plasma tube; analyzing the light collected from the first spectrometer to determine whether the oxygen plasma cleaning of the plasma tube is complete based upon the intensity of the emitted light; and once the intensity of the emitted light exceeds a predefined intensity level, shutting down the flow of oxygen and the radio frequency energy for the plasma source.

In some embodiments, the method further comprises after the oxygen plasma cleaning has been completed, restarting the flow of a first gas into the plasma source; providing radio frequency energy into the plasma source to maintain a plasma in the plasma tube; extracting charged particles from the plasma tube; and focusing the charged particles into a beam within a focusing column and directing the beam onto or near a workpiece.

In some embodiments, the method further comprises providing user input, said user input including a set of predetermined plasma source properties and said user input being incorporated in controlling the plasma source using feedback loops such that the plasma source is adjusted to match the set of predetermined plasma source properties.

In some embodiments, controlling the plasma source based on the analysis of the emission spectrum of light collected from the first spectrometer includes monitoring the existence of plasma within the source tube, the intensity of plasma generation within the source tube, the elemental composition of the plasma within the source tube in cases where multiple gas species are being simultaneously ionized, the ion species composition of the plasma in cases of a single species being ionized, or the combined ion species composition of the plasma where multiple gas species are being simultaneously ionized.

In some embodiments, controlling the plasma source includes varying operating parameters so that properties of the light collected from the first spectrometer match properties of a desired ion composition. In some embodiments, the method further comprises controlling components of the focusing column, controlling components comprises controlling a mass filter to transmit a desired ion species, selecting a beam acceptance aperture for a desired ion beam current, or controlling the voltages on focusing lenses. In some embodiments, controlling the plasma source is an automated process.

According to some embodiments of the present invention, a charged particle beam system comprises a plasma source including a plasma tube for containing a plasma; a conductor for providing radio frequency energy into the plasma tube; a focusing column for focusing a beam of charged particles onto or near a sample; and a first spectrometer; characterized in that the first spectrometer collects light emitted from within the plasma tube; and the charged particle beam system further comprises a controller system for regulating the plasma source and/or the focusing column based on analysis of the light collected from the first spectrometer.

In some embodiments, user input is provided to the controller system, the user input being incorporated into feedback loops to regulate the plasma source and/or focusing column.

In some embodiments, the controller system monitors the existence of plasma within the source tube, the intensity of the plasma within the source tube, the elemental composition of the plasma within the source tube in cases where multiple gas species are being simultaneously ionized, or the ion species composition of the plasma within the source tube in cases of single gas species being ionized.

In some embodiments, the controller system controls operating parameters of the charged particle beam system such that the properties of the plasma source match a set of predetermined properties.

In some embodiments, the charged particle beam system further comprises a second spectrometer for collecting light emitted from the sample and wherein analysis of the light collected from the second spectrometer is used to provide endpoint detection during processing of the sample.

Although the description of the present invention above is mainly directed at an apparatus, it should be recognized that a method of using the claimed apparatus would further be within the scope of the present invention. Further, it should be recognized that embodiments of the present invention can be implemented via computer hardware or software, or a combination of both. The methods can be implemented in computer programs using standard programming techniques-including a computer-readable storage medium configured with a computer program, where the storage medium so configured causes a computer to operate in a specific and predefined manner-according to the methods and figures described in this Specification. Each program may be implemented in a high level procedural or object oriented programming language to communicate with a computer system. However, the programs can be implemented in assembly or machine language, if desired. In any case, the language can be a compiled or interpreted language. Moreover, the program can run on dedicated integrated circuits programmed for that purpose.

Further, methodologies may be implemented in any type of computing platform, including but not limited to, personal computers, mini-computers, main-frames, workstations, networked or distributed computing environments, computer platforms separate, integral to, or in communication with charged particle tools or other imaging devices, and the like. Aspects of the present invention may be implemented in machine readable code stored on a storage medium or device, whether removable or integral to the computing platform, such as a hard disc, optical read and/or write storage mediums, RAM, ROM, and the like, so that it is readable by a programmable computer, for configuring and operating the computer when the storage media or device is read by the computer to perform the procedures described herein. Moreover, machine-readable code, or portions thereof, may be transmitted over a wired or wireless network. The invention described herein includes these and other various types of computer-readable storage media when such media contain instructions or programs for implementing the steps described above in conjunction with a microprocessor or other data processor. The invention also includes the computer itself when programmed according to the methods and techniques described herein.

Computer programs can be applied to input data to perform the functions described herein and thereby transform the input data to generate output data. The output information is applied to one or more output devices such as a display monitor. In preferred embodiments of the present invention, the transformed data represents physical and tangible objects, including producing a particular visual depiction of the physical and tangible objects on a display.

The invention has broad applicability and can provide many benefits as described and shown in the examples above. The embodiments will vary greatly depending upon the specific application, and not every embodiment will provide all of the benefits and meet all of the objectives that are achievable by the invention. To the extent that any term is not specially defined in this specification, the intent is that the term is to be given its plain and ordinary meaning. The accompanying drawings are intended to aid in understanding the present invention and, unless otherwise indicated, are not drawn to scale.

In the discussion herein and in the claims, the terms "including" and "comprising" are used in an open-ended fashion, and thus should be interpreted to mean "including, but not limited to ...". Further, whenever the terms "automatic," "automated," or similar terms are used herein, those terms will be understood to include manual initiation of the automatic or automated process or step. The term "FIB" or "focused ion beam" is used herein to refer to any collimated ion beam, including a beam focused by ion optics and shaped ion beams.

Although the present invention and its advantages have been described in detail, it should be understood that various changes, substitutions and alterations can be made herein without departing from the spirit and scope of the invention as defined by the appended claims. Moreover, the scope of the present application is not intended to be limited to the particular embodiments of the process, machine, manufacture, composition of matter, means, methods and steps described in the specification. As one of ordinary skill in the art will readily appreciate from the disclosure of the present invention, processes, machines, manufacture, compositions of matter, means, methods, or steps, presently existing or later to be developed that perform substantially the same function or achieve substantially the same result as the corresponding embodiments described herein may be utilized according to the present invention. Accordingly, the appended claims are intended to include within their scope such processes, machines, manufacture, compositions of matter, means, methods, or steps.

## Claims

1. A method of operating an inductively coupled plasma source including a plasma chamber comprising:
providing a flow of a first gas into the plasma source;
providing radio frequency energy into the plasma source to maintain a plasma in the plasma chamber;
extracting charged particles from the plasma chamber;
focusing the charged particles into a beam in a focusing column and directing the beam onto or near a workpiece; and
collecting light from the plasma chamber;
**characterized in that** a first spectrometer (252) analyzes the light collected from the plasma chamber, the plasma source is adjusted based on the analysis of the light collected from the first spectrometer; and
a voltage of 20 kV to 30 kV is applied to the plasma in the plasma chamber before charged particles are extracted and focused into the beam in the focusing column.

2. The method of claim 1 further comprising providing a second spectrometer (290) to collect light emitted from the sample as a result of the impact of the beam with the workpiece and analyzing the light collected from the second spectrometer.

3. The method of claim 2, in which analyzing the light collected from the second spectrometer provides a method of endpoint determination when processing the workpiece.

4. The method of any of claims 1 - 3 further comprising:
upon a determination that the plasma chamber should be cleaned, shutting down the flow of the first gas and the radio frequency energy for the plasma source;
then, providing a flow of oxygen into the plasma source;
restarting the radio frequency energy provided to the source to maintain an oxygen plasma to clean the plasma chamber;
analyzing the light collected from the first spectrometer to determine whether the oxygen plasma cleaning of the plasma tube is complete based upon the intensity of the emitted light; and
once the intensity of the emitted light exceeds a predefined intensity level, shutting down the flow of oxygen and the radio frequency energy for the plasma source.

5. The method of any of claims 1 - 4 further comprising:
after the oxygen plasma cleaning has been completed, restarting the flow of a first gas into the plasma source;
providing radio frequency energy into the plasma source to maintain a plasma in the plasma chamber;
extracting charged particles from the plasma chamber; and
focusing the charged particles into a beam within a focusing column and directing the beam onto or near a workpiece.

6. The method of any of claims 1 - 5 further comprising providing user input, said user input including a set of predetermined plasma source properties and said user input being incorporated in controlling the plasma source using feedback loops such that the plasma source is adjusted to match the set of predetermined plasma source properties.

7. The method of any of claims 1 - 6 in which controlling the plasma source based on the analysis of the emission spectrum of light collected from the first spectrometer includes monitoring the existence of plasma within the plasma chamber, the intensity of plasma generation within the plasma chamber, the elemental composition of the plasma within the plasma chamber in cases where multiple gas species are being simultaneously ionized, the ion species composition of the plasma in cases of a single species being ionized, or the combined ion species composition of the plasma where multiple gas species are being simultaneously ionized.

8. The method of any of claims 1 - 7 in which controlling the plasma source includes varying operating parameters so that properties of the light collected from the first spectrometer match properties of a desired ion composition.

9. The method of any of claims 1 - 8 further comprising controlling components of the focusing column, controlling components comprises controlling a mass filter to transmit a desired ion species, selecting a beam acceptance aperture for a desired ion beam current, or controlling the voltages on focusing lenses.

10. The method of any of claims 1 - 9 in which controlling the plasma source is an automated process.

11. A charged particle beam system, comprising:
a plasma source including a plasma tube for containing a plasma;
a conductor for providing radio frequency energy into the plasma tube;
a focusing column for focusing a beam of charged particles onto or near a sample; and
a controller system for regulating the plasma source and/or the focusing column based on analysis of the light collected from the first spectrometer;
**characterized in that** the charged particle system further comprises a first spectrometer for collecting light emitted from within the plasma tube; and
a source electrode (226) for applying a voltage of 20 kV to 30 kV to plasma in a plasma chamber (220).

12. The charged particle beam system of claim 11, wherein user input is provided to the controller system, the user input being incorporated into feedback loops to regulate the plasma source and/or focusing column.

13. The charged particle beam system of claim 11 or claim 12 wherein the controller system monitors the existence of plasma within the source tube, the intensity of the plasma within the source tube, the elemental composition of the plasma within the source tube in cases where multiple gas species are being simultaneously ionized, or the ion species composition of the plasma within the source tube in cases of single gas species being ionized.

14. The charged particle beam system of any of claims 11 - 13, in which the controller system controls operating parameters of the charged particle beam system such that the properties of the plasma source match a set of predetermined properties.

15. The charged particle beam system of any of claims 11 - 14 further comprising a second spectrometer for collecting light emitted from the sample and wherein analysis of the light collected from the second spectrometer is used to provide endpoint detection during processing of the sample.
